# EUROPEAN PATENT SPECIFICATION

(11) **EP 0 671 770 B1**
(45) Date of publication and mention of the grant of the patent: **02.08.2000**
(21) Application number: 94301701.2
(22) Date of filing: 10.03.1994
(51) Int. Cl.: H01L 29/861, H01L 29/866, H01L 21/329, H01L 21/205

(54) **Multilayer epitaxy for a silicon diode**
Mehrschichtige Epitaxie für eine Siliziumdiode
Epitaxie multi-couche pour une diode en silicium

(43) Date of publication of application: 13.09.1995
(73) Proprietor: GENERAL SEMICONDUCTOR, Inc., Melville, NY 11747-9023 (US)
(72) Inventor: Chan, Joseph, Kings Park, New York 11754 (US); LaTerza, Lawrence, Miller Place, New York 11764 (US); Salih, Ali, Power Products Division, Phoenix, Arizona 85008 (US); Hirtz, Reinhold, Huntington, New York 11747 (US); Zakaluk, Gregory, North Seaford, New York 11783 (US); Garbis, Dennis, Huntington Station, New York 11746 (US)
(74) Representative: Allam, Peter Clerk

(56) References cited:
- EP-A- 0 217 780
- DE-A- 3 112 921
- GB-A- 2 019 644
- US-A- 4 696 701
- US-A- 4 859 626
- JOURNAL OF THE ELECTROCHEMICAL SOCIETY, NOV. 1975, USA, VOL. 122, NR. 11, PAGE(S) 1523 - 1531, ISSN 0013-4651 Ishii T et al 'Silicon epitaxial wafer with abrupt interface by two-step epitaxial growth technique'

## Description

The present invention relates to a structure of semiconductor material for use in the fabrication of a semiconductor device having an epitaxial structure and to a method of fabricating same. The method is particularly applicable to the fabrication of a semiconductor material on a substrate in a single continuous operation in the chamber of a chemical vapor deposition reactor.

Semiconductors of many types are formed on wafers which are commonly made of silicon crystal material. The material is produced by an epitaxial growth process in accordance with well known chemical vapor deposition principles. The growth of the material takes place in vessels called chemical vapor deposition (CVD) reactors specially designed for this purpose. Such reactors have facility to control growth conditions such as temperature and pressure, as well as impurity concentrations.

Certain types of semiconductors such as power diodes and Zener diodes have specific electrical parameter requirements, for example, forward voltage drop, leakage current and breakdown voltages, which are difficult to accurately control by conventional diffusion means. A multilayer epitaxial structure as proposed in this disclosure will provide accurate controls to meet the device electrical parameter requirements. In addition, the need for impurity diffusion is eliminated.

The said multilayer structure is epitaxially grown with a top layer having high impurity concentration and middle layer having light impurity concentration deposited on a substrate of high impurity concentration with opposite or same dopant type.

However, the formation of heavily doped layers by epitaxial growth usually means slow growth rates and the presence of high impurity concentrations in the material leads to problems with "outdiffusion", where the high dopant concentration layers tend to contaminate low concentration layers, as the material containing the heavily doped layer is heated to high temperature for processing. Another problem associated with heavily doped epitaxially grown layer is "autodoping" in which dopant moves into the gas stream. This autodopant together with highly concentrated dopant gas used, contaminates the reactor chamber and quartz ware and therefore tends to degrade resistivity control on subsequent runs (the so called "memory effect"). Consequently, where high impurity concentrations are required, it has been necessary to form the doped layer by diffusion in a separate vessel called a diffusion tube.

There will be described below a multilayer epitaxial structure with a heavily doped layer and a lightly doped layer and a method for fabricating same without diffusion which overcomes the problems normally associated with use of materials with high impurity concentrations in a CVD reactor. The process to be described permits epitaxial technology to replace diffusion entirely. Accordingly, it permits the structure to be formed by a single continuous epitaxial process in a single apparatus. Moreover, the method described produces a superior quality product, improved device performance and higher device yields.

In brief, the fabrication of the semiconductor structure starts with a heavily doped substrate of a silicon material, preferably with a resistivity of less than .0035 ohm cm. Very thin "cap" layers are formed in succession on the substrate, rapidly followed by hydrogen purges which deplete the dopant concentration in the reactor chamber. A first epitaxial layer which is relatively lightly doped and has a relatively high resistivity (0.1 to 200 ohm cm.) is grown over the "capped" substrate to a thickness of less than 100 microns. A relatively heavily doped second epitaxial layer is then grown over the first epitaxial layer. The second epitaxial layer preferably has a carrier concentration greater than 1 x 10¹⁹ per cm³ and hence a very relatively low resistivity. It has a polarity opposite to that of the substrate.

The practice of the present invention enables us to provide a multilayer epitaxial structure and method for fabricating same which overcomes the problems associated with dopant memory effect and autodopant effect in a chemical vapor deposition reactor, permitting formation of a multilayer structure by an all epitaxial process which can take place in a single continuous operation in a single vessel. The substrate is capped with two thin sub-layers to minimize outdiffusion to the subsequently grown epitaxial layer and contamination of the vessel.

Patent specification GB-A-2 019 644 (Philips) discloses a method of fabricating a semiconductor material for use in the fabrication of a semiconductor device, comprising:
providing a silicon substrate that is relatively heavily-doped and of a given polarity; and
producing a multiplicity of silicon layers including a cap layer on said substrate by an all epitaxial process performed in a CVD reactor chamber.

In GB-A-2 019 644 a mask layer is grown as a thick layer on one major surface of the substrate and subsequently etched to a thin layer (from 1.3 to 0.3µm thickness). The etching step also provides for the growth of another layer on the opposite major surface of the substrate.

The method of fabricating a semiconductor material as set forth above is characterized according to the invention in that said multiplicity of layers is produced by:
a) growing a first relatively thin cap sub-layer over the substrate and purging said chamber with hydrogen to dopant deplete said first sub-layer;
b) growing a second relatively thin cap sub-layer over the first sub-layer and purging said chamber with hydrogen to dopant deplete said second sub-layer;
c) growing a relatively lightly-doped epitaxial layer above said second sub-layer; and
d) growing a relatively heavily-doped epitaxial layer of the opposite polarity type to said substrate above said relatively lightly-doped epitaxial layer.

GB-A-2 019 644 also discloses a structure of semiconductor material for use in the fabrication of a semiconductor device, comprising:
a silicon substrate that is relatively heavily-doped to be of a given polarity, and a multiplicity of silicon layers including a cap layer epitaxially grown on said substrate.

As already stated above in GB-A-2 019 644, the substrate is provided with a thin mask layer whose thickness has been controlled by etching a thicker layer first grown on the substrate. There is no mention of the thin mask layer being dopant-depleted.

According to another aspect of the present invention, the structure of semiconductor material set forth above is characterized in that said multiplicity of layers comprises:
said cap layer formed to be dopant depleted and comprising first and second relatively thin sub-layers, each of which is dopant depleted;
a relatively lightly-doped layer grown over said cap layer; and
a relatively heavily-doped layer grown over said relatively lightly-doped layer and of opposite polarity to said substrate.

In one implementation of the invention, the following parameters may be selected. The substrate preferably has a resistivity of less than .0035 ohm cm, and preferably in the range .001 to .002 ohm cm. The lightly doped epitaxial layer preferably has a resistivity in the range of 0.1 to 200 ohm cm. and a thickness of less than 100 microns.

The lightly doped epitaxial layer may have the same polarity as the substrate or the opposite polarity. The heavily doped epitaxial layer preferably has a thickness less than 100 microns.

The carrier concentration of the substrate is preferably greater than 1 x 10¹⁹ per cm³. The carrier concentration of the heavily doped epitaxial layer is also preferably greater than 1 x 10¹⁹ per cm³.

In one proposed multilayer epitaxial structure embodying the invention, the substrate has a resistivity of less than .002 ohm cm, and preferably in the range of .001 to .002 ohm cm. A first epitaxial layer, situated above the sub-layers of the cap, is grown having a resistivity in the range of less than 50 ohm cm, and a thickness of less than 100 microns, and preferably in the range of 5-100 microns. A second epitaxial layer, situated above said first epitaxial layer, is grown having a resistivity of less than .005 ohm cm. and thickness of less than 100 microns preferably in the range of 5-100 microns. The substrate and the second epitaxial layer are of opposite polarity.

Preferably in practising the method of the invention, the step of forming the two sub-layers of the cap layer comprises heating the substrate, introducing silicon gas with or without dopant gas to grow a thin sub-layer and purging the sub-layer with hydrogen to deplete the dopant from the layer. Preferably the silicon is introduced into the chamber through the use of gases selected from a group of compounds consisting of trichlorosilane, chlorosilane or silane.

The growing of the first, lightly-doped, epitaxial layer is effected in the chemical vapor deposition reactor in a hydrogen ambient at a temperature between 1000°C and 1200°C. The layer is formed with a resistivity of less than 200 ohm cm, preferably a resistivity of less than 50 ohm cm. and a thickness of 5 to 100 microns.

Preferably the growing of the second, highly-doped, epitaxial layer is effected in the chemical vapor deposition reactor in a gas environment which is the source of a dopant selected from the group of arsenic, phosphorus and antimony. The second epitaxial layer is grown with a resistivity of less than .005 ohm cm. and a thickness of less than 100 microns. Preferably, the layer is doped to a concentration of greater than 1 x 10¹⁹ per cm³.

A multilayer epitaxial structure and method for fabricating same in accordance with this invention will now be described with reference to the accompanying drawings, wherein like numerals refer to like parts and in which:
Fig. 1 is an idealized cross-sectional view of the substrate;
Fig. 2 is a view similar to Fig. 1 showing the first epitaxial layer on the "capped" substrate; an
Fig. 3 is a view similar to Fig. 2 showing the second epitaxial layer.

Certain modifications to the gas feed and venting system for the CVD reactor, as described in detail in our copending application 94 301 700.4 (publication number EP-A-0670484), make the process more suitable for use in large scale production. This application discloses a gas flow system which reduces residue dopants which would otherwise remain in the reactor or associated plumbing and may adversely affect subsequent runs by degrading resistivity control. The reader is referred to that application for further information in that regard.

The invention is described herein in the context of the processing of material for the fabrication of power diodes. It is particularly useful in this application because this process eliminates the necessity for front and back diffusions normally required when fabricating such devices. However, the invention should not be construed as being limited to this specific application. Other uses of the invention in the fabrication devices of many other configurations will be obvious to those skilled in the art.

The process begins with a heavily doped P-type substrate, preferably with an impurity concentration typically greater than 1 x 10¹⁹ per cm³ and a resistivity of less than .0035 ohm cm, typically in the .001 to .002 ohm cm range. It may have a thickness of 14 to 16 mils (1 mil = 2.54 x 10⁻⁵m). Conventionally, such a substrate, after being grown in a CVD reactor, would be transferred to a separate vessel, known as a diffusion tube, for formation of the doped regions using well known diffusion techniques. However, with the present proposal , the multilayer structure, including heavily doped layers can be made in the CVD chamber itself, in a single continuous epitaxial process.

The susceptor in the CVD chamber is preferably silicon coated. This minimizes autodoping from the backside of the substrate. Silicon capping techniques are used to minimize outdiffusion from the substrate.

After heating the substrate in the CVD chamber and cleaning the surface with HCl, the substrate surface is "capped". Capping is accomplished by growing a cap layer 10 of very thin silicon sublayers on the substrate and depleting the dopant level of each sublayer after it is formed.

The substrate is heated to a temperature over 1000°C in an H₂ atmosphere containing a silicon source gas to form each sublayer. The growth rate is relatively fast, approximately 2.5 microns per minute, to minimize cycle time. After each thin sub layer is formed, it is subjected to a hydrogen purge which depletes the dopant level dramatically. The cycle is then preferably repeated so that the cap layer 10 is formed of at least two sublayers of depleted silicon. At present, two cap sublayers are preferred, although more may be employed, if desirable.

The silicon source for the cap layer 10 is preferably trichlorosilane. It is introduced in the reactor in a hydrogen ambient of one atmospheric pressure and at a temperature between 1000° and 1200°C. However, other sources of silicon, such as chlorosilane or silane, can be used with appropriate temperature and growth rates.

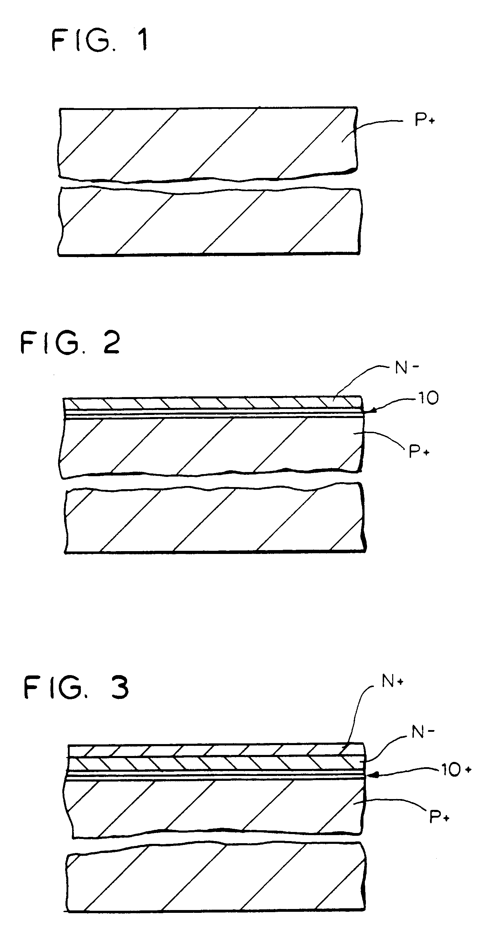

The first layer is then epitaxially grown over the capped substrate surface in the CVD reactor. This is a relatively lightly doped, high ohmic region and can be of either polarity. In the example, the layer maybe N- type. An appropriate source gas provides the necessary impurities. This layer has a resistivity in the range of 0.1 to 200 ohm cm; preferably less than 50 ohm cm. It has a thickness of between 0.1 and 100 microns, preferably between 5 an 100 microns. The structure is seen in Fig. 2.

A second layer is then epitaxially grown on the first epitaxial layer in the CVD reactor. This layer will be of a low ohmic region, and is relatively heavily doped, like the substrate. It is, however, of opposite polarity to the substrate, in this case, N+. Phosphine may be use as a source of phosphorus ions. Alternatively, arsenic or antimony ions can be employed. An impurity concentration of greater than 1 x 10¹⁹ per cm³ is preferred, with a resistivity similar to that of the substrate. The structure is seen in Fig. 3

Throughout the process, the growth temperatures are 1000° and 1200°C and pressure in the reactor is kept at 1 atmospheric in a hydrogen ambient. Silicon capping techniques are employed to minimize outdiffusion from the substrate. Silicon-coated susceptors are employed in the CVD reactor to minimize autodoping from the backside of the substrates. Hydrogen purges are employed to deplete the remaining capping sublayers after growth. Fast growth rates of approximately 2.5 microns per minute minimize cycle time.

This process permits the entire structure to be achieved in a single continuous production run in a single apparatus. Moreover, the process eliminates the need for front and back diffusions normally required for power semiconductor devices.

This structure and method improves the forward voltage drop, leakage current and breakdown voltage distribution characteristics of the semiconductor devices. The heavily doped layers improve ohmic contact during metallization and packaging. It also reduces processing steps by simplifying the process to be all expitaxial and at the same time improves fabrication yields.

It should now be appreciated that there has been described a multilayer epitaxial structure and an all epitaxial method for fabricating same. The structure includes a heavily doped, low resistivity substrate of one polarity, a high resistivity, middle layer grown on the capped substrate and a heavily doped, low resistivity top layer of opposite polarity to the substrate grown on the middle layer. The interfaces between one low ohmic region (substrate or top layer) and the high ohmic region (middle layer) form the electronic junctions.

## Claims

1. A structure of semiconductor material for use in the fabrication of a semiconductor device, comprising:
a silicon substrate (P+) that is relatively heavily-doped to be of a given polarity, and
a multiplicity of silicon layers (10, N+, N-) including a cap layer (10) epitaxially grown on said substrate (P+), characterized in that said multiplicity of layers (10, N+, N-) comprises:
said cap layer (10) formed to be dopant depleted and comprising first and second relatively thin sub-layers, each of which is dopant depleted;
a relatively lightly-doped layer (N-) grown over said cap layer (10); and
a relatively heavily-doped layer (N+) grown over said relatively lightly-doped layer and of opposite polarity to said substrate (P+).

2. The structure of Claim 1 wherein said substrate (P+) has a resistivity of less than .0035 ohm-cm.

3. The structure of Claim 2, wherein said substrate has a resistivity in the range of .001 to .002 ohm-cm.

4. The structure of Claim 1, wherein said substrate has a resistivity less than .002 ohm-cm.

5. The structure of any preceding claim wherein the impurity concentration of said substrate (P+) is greater than 1 x 10¹⁹ per cm³.

6. The structure of any preceding claim wherein said lightly-doped epitaxial layer (N-) has a resistivity in the range of 0.1 to 200 ohm-cm.

7. The structure of any one of Claims 1 to 5, wherein said lightly-doped epitaxial layer (N-) has a resistivity of less than 50 ohm-cm.

8. The structure of any preceding claim, wherein said lightly-doped epitaxial layer (N-) has a thickness in the range of 5-100 microns.

9. The structure of any one of Claims 1 to 7, wherein said lightly-doped epitaxial layer (N-) has a thickness of less than 100 microns.

10. The structure of any preceding claim, wherein said lightly-doped epitaxial layer (N-) is of said given polarity.

11. The structure of any one of Claims 1 to 10, wherein said lightly-doped epitaxial layer (N-) is of the opposite polarity to said given polarity.

12. The structure of any preceding claim, wherein said heavily-doped epitaxial layer (N+) has a thickness of less than 100 microns.

13. The structure of any one of Claims 1 to 11, wherein said heavily-doped epitaxial layer (N+) has a thickness in the range of 5 to 100 microns.

14. The structure of any one of Claims 1 to 12 wherein heavily-doped epitaxial layer (N+) has a resistivity of less than .005 ohm-cm.

15. The structure of any preceding claim, wherein the impurity concentration of said heavily-doped layer (N+) is greater than 1 x 10¹⁹ per cm.

16. A method of fabricating a semiconductor material for use in the fabrication of a semiconductor device, comprising:
providing a silicon substrate (P+) that is relatively heavily-doped and of a given polarity; and
producing a multiplicity of silicon layers (10, N-, N+) including a cap layer (10) on said substrate by an all epitaxial process performed in a CVD reactor chamber, characterized in that said multiplicity of layers (10, N-, N+) is produced by:
a. growing a first relatively thin cap sub-layer over the substrate and purging said chamber with hydrogen to dopant deplete said first sub-layer;
b. growing a second relatively thin cap sub-layer over the first sub-layer and purging said chamber with hydrogen to dopant deplete said second sub-layer;
c. growing a relatively lightly-doped epitaxial layer (N-) above said second sub-layer; and
d. growing a relatively heavily-doped epitaxial layer (N+) of the opposite polarity type to said substrate (P+) above said relatively lightly-doped epitaxial layer (N-).

17. The method of Claim 16 wherein the substrate has a resistivity of less than .0035 ohm-cm.

18. The method of Claim 16 wherein the substrate has a resistivity in the range of .001 to .002 ohm-cm.

19. The method of any one of Claims 16 to 18 wherein the growing of said cap sub-layers comprises the step of heating the substrate in an atmosphere containing a source of silicon obtained from a group of compounds consisting of trichlorosilane, chlorosilane and silane.

20. the method of any one of Claims 16 to 19 wherein the growing of said lightly-doped layer is effected in a hydrogen ambient at a temperature between 1000°C and 1200°C.

21. The method of any one of Claims 16 to 20 wherein the said lightly-doped layer has a resistivity of less than 200 ohm-cm.

22. The method of Claim 21 wherein said lightly-doped layer has a resistivity of less than 50 ohm-cm.

23. The method of any one of Claims 16 to 22, wherein said lightly-doped layer has a thickness of 5 to 100 microns.

24. The method of any one of Claims 16 to 23, wherein said heavily-doped layer is grown on said lightly-doped layer in a gas environment which is the source of dopant selected from arsenic, phosphorus and antimony.

## Patentansprüche

1. Eine Struktur aus Halbleitermaterial zur Verwendung bei der Herstellung einer Halbleitervorrichtung, aufweisend:
ein Siliziumsubstrat (P+), das relativ stark dotiert ist, so daß es eine vorgegebene Polarität aufweist, und
mehrere Siliziumschichten (10, N+, N-) einschließlich einer Deckschicht (10), die epitaktisch auf dem Substrat (P+) aufgewachsen ist,
**dadurch gekennzeichnet**,
daß die mehreren Schichten (10, N+, N-) umfassen:
die Deckschicht (10), die so gebildet ist, daß sie an Dotierstoffen verarmt ist und die eine erste und zweite relativ dünne Teilschicht aufweist, welche jeweils an Dotierstoffen verarmt sind;
eine relativ schwach dotierte Schicht (N-), die über dieser Deckschicht (10) aufgewachsen ist; und
eine relativ stark dotierte Schicht (N+), die über der relativ schwach dotierten Schicht aufgewachsen und von entgegengesetzter Polarität zu der des Substrates (P+) ist.

2. Die Struktur nach Anspruch 1, wobei das Substrat (P+) einen spezifischen Widerstand von weniger als 0,0035 Ohm·cm aufweist.

3. Die Struktur nach Anspruch 2, wobei das Substrat einen spezifischen Widerstand im Bereich von 0,001 bis 0,002 Ohm·cm aufweist.

4. Die Struktur nach Anspruch 1, wobei das Substrat (P+) einen spezifischen Widerstand von weniger als 0,002 Ohm·cm aufweist.

5. Die Struktur nach einem der vorhergehenden Ansprüche, wobei die Störstellenkonzentration des Substrates (P+) größer als 1 x 10¹⁹ pro cm³ ist.

6. Die Struktur nach einem der vorhergehenden Ansprüche, wobei die schwach dotierte epitaktische Schicht (N-) einen spezifischen Widerstand im Bereich von 0,1 bis 200 Ohm·cm aufweist.

7. Die Struktur nach einem der Ansprüche 1 bis 5, wobei die schwach dotierte epitaktische Schicht (N-) einen spezifischen Widerstand von weniger als 50 Ohm·cm aufweist.

8. Die Struktur nach einem der vorhergehenden Ansprüche, wobei die schwach dotierte epitaktische Schicht (N-) eine Dicke im Bereich von 5 - 100 Mikrometern aufweist.

9. Die Struktur nach einem der Ansprüche 1 bis 7, wobei die schwach dotierte epitaktische Schicht (N-) eine Dicke von weniger als 100 Mikrometern aufweist.

10. Die Struktur nach einem der vorhergehenden Ansprüche, wobei die schwach dotierte epitaktische Schicht (N-) die vorgegebene Polarität aufweist.

11. Die Struktur nach einem der Ansprüche 1 bis 10, wobei die schwach dotierte epitaktische Schicht (N-) die zu der vorgegebenen Polarität entgegengesetzte Polarität aufweist.

12. Die Struktur nach einem der vorhergehenden Ansprüche, wobei die stark dotierte epitaktische Schicht (N+) eine Dicke von weniger als 100 Mikrometern aufweist.

13. Die Struktur nach einem der Ansprüche 1 bis 11, wobei die stark dotierte epitaktische Schicht (N+) eine Dicke im Bereich von 5 bis 100 Mikrometern aufweist.

14. Die Struktur nach einem der Ansprüche 1 bis 12, wobei die stark dotierte epitaktische Schicht (N+) einen spezifischen Widerstand von weniger als 0,005 Ohm·cm aufweist.

15. Die Struktur nach einem der vorhergehenden Ansprüche, wobei die Störstellenkonzentration der stark dotierten Schicht (N+) größer als 1 x 10¹⁹ pro cm³ ist.

16. Ein Verfahren zur Herstellung eines Halbleitermaterial zur Verwendung bei der Herstellung einer Halbleitervorrichtung, beinhaltend:
die Bereitstellung eines Siliziumsubstrates (P+), das relativ stark dotiert ist und eine vorgegebene Polarität aufweist; und
die Herstellung mehrerer Siliziumschichten (10, N-, N+) einschließlich einer Deckschicht (10) auf dem Substrat durch ein vollständig epitaktisches Verfahren, das in einer CVD-Reaktorkammer ausgeführt wird,
**dadurch gekennzeichnet**,
daß die mehreren Schichten (10, N-, N+) hergestellt werden durch:
a) Aufwachsen einer ersten relativ dünnen Deck-Teilschicht auf dem Substrat und Säubern der Kammer mit Wasserstoff, um die erste Teilschicht an Dotierstoffen zu verarmen;
b) Aufwachsen einer zweiten relativ dünnen Deck-Teilschicht auf der ersten Deck-Teilschicht und Säubern der Kammer mit Wasserstoff, um die zweite Teilschicht an Dotierstoffen zu verarmen;
c) Aufwachsen einer relativ schwach dotierten epitaktischen Schicht (N-) über der zweiten Teilschicht; und
d) Aufwachsen einer relativ stark dotierten epitaktischen Schicht (N+) entgegengesetzter Polarität zu der des Substrates (P+) auf der relativ schwach dotierten epitaktischen Schicht (N-).

17. Das Verfahren nach Anspruch 16, wobei das Substrat einen spezifischen Widerstand von weniger als 0,0035 Ohm·cm aufweist.

18. Das Verfahren nach Anspruch 16, wobei das Substrat einen spezifischen Widerstand im Bereich von 0,001 bis 0,002 Ohm·cm aufweist.

19. Das Verfahren nach einem der Ansprüche 16 bis 18, wobei das Aufwachsen der Deck-Teilschichten den Schritt der Heizung des Substrates in einer Atmosphäre beinhaltet, die eine Quelle für Silizium beinhaltet, das aus einer Gruppe von Verbindungen erhalten wird, welche Trichlorsilan, Chlorsilan und Silan beinhaltet.

20. Das Verfahren nach einem der Ansprüche 16 bis 19, wobei das Aufwachsen der schwach dotierten Schicht in einer Wasserstoffumgebung bei einer Temperatur zwischen 1000°C und 1200°C erfolgt.

21. Das Verfahren nach einem der Ansprüche 16 bis 20, wobei die schwach dotierte Schicht einen spezifischen Widerstand von weniger als 200 Ohm·cm aufweist.

22. Das Verfahren nach Anspruch 21, wobei die schwach dotierte Schicht einen spezifischen Widerstand von weniger als 50 Ohm·cm aufweist.

23. Das Verfahren nach einem der Ansprüche 16 bis 22, wobei die schwach dotierte Schicht eine Dicke im Bereich von 5 bis 100 Mikrometern aufweist.

24. Das Verfahren nach einem der Ansprüche 16 bis 23, wobei die stark dotierte Schicht auf der schwach dotierten Schicht in der Umgebung eines Gases aufwächst, welches die Quelle des Dotierstoffes darstellt und aus Arsen, Phosphor und Antimon ausgewählt wird.

## Revendications

1. Une structure de matériau semiconducteur pour utilisation dans la fabrication d'un dispositif semiconducteur, englobant :
un substrat en silicium (P+) qui est relativement fortement dopé pour être d'une polarité donnée, et
une multiplicité de couches de silicium (10, N+, N-) englobant une couche de couverture (10) tirée épitaxialement sur ledit substrat (P+), caractérisée en ce que ladite multiplicité de couches (10, N+, N-) englobe :
ladite couche de couverture (10) formée de façon à être appauvrie en dopant et englobant lesdites première et deuxième sous-couches relativement minces, dont chacune est appauvrie en dopant ;
une couche relativement légèrement dopée (N-) tirée au-dessus de ladite couche de couverture (10) ; et
une couche relativement fortement dopée (N+) tirée au-dessus de ladite couche relativement légèrement dopée et de polarité opposée audit substrat (P+).

2. La structure de la Revendication 1, dans laquelle ledit substrat (P+) a une résistivité inférieure à 0,0035 ohm-cm.

3. La structure de la Revendication 2, dans laquelle ledit substrat a une résistivité dans la plage de 0,001 à 0,002 ohm-cm.

4. La structure de la Revendication 1, dans laquelle ledit substrat a une résistivité inférieure à 0,002 ohm-cm.

5. La structure selon l'une quelconque des revendications précédentes, dans laquelle la concentration d'impuretés dudit substrat (P+) excède 1 x 10¹⁹/cm³.

6. La structure selon l'une quelconque des revendications précédentes, dans laquelle ladite couche épitaxiale légèrement dopée (N-) a une résistivité dans la plage de 0,1 à 200 ohms-cm.

7. La structure selon l'une quelconque des Revendications 1 à 5, dans laquelle ladite couche épitaxiale légèrement dopée (N-) a une résistivité inférieure à 50 ohms-cm.

8. La structure selon l'une quelconque des revendications précédentes, dans laquelle ladite couche épitaxiale légèrement dopée (N-) a une épaisseur dans la plage de 5 à 100 microns.

9. La structure selon l'une quelconque des revendications 1 à 7, dans laquelle ladite couche épitaxiale légèrement dopée (N-) a une épaisseur inférieure à 100 microns.

10. La structure selon l'une quelconque des revendications précédentes, dans laquelle ladite couche épitaxiale légèrement dopée (N-) possède ladite polarité donnée.

11. La structure selon l'une quelconque des Revendications 1 à 10, dans laquelle ladite couche épitaxiale légèrement dopée (N-) a la polarité opposée à ladite polarité donnée.

12. La structure selon l'une quelconque des revendications précédentes, dans laquelle ladite couche épitaxiale fortement dopée (N+) a une épaisseur inférieure à 100 microns.

13. La structure selon l'une quelconque des Revendications 1 à 11, dans laquelle ladite couche épitaxiale fortement dopée (N+) a une épaisseur dans la plage de 5 à 100 microns.

14. La structure selon l'une quelconque des Revendications 1 à 12, dans laquelle ladite couche épitaxiale fortement dopée (N+) a une résistivité inférieure à 0,005 ohm-cm.

15. La structure selon l'une quelconque des revendications précédentes, dans laquelle la concentration en impuretés de ladite couche fortement dopée (N+) excède 1 x 10¹⁹/cm.

16. Un procédé de fabrication d'un matériau semiconducteur pour utilisation dans la fabrication d'un dispositif semiconducteur, englobant :
prévision d'un substrat en silicium (P+) qui est relativement fortement dopé et d'une polarité donnée ; et
production d'une multiplicité de couches de silicium (10, N-, N+) englobant une couche de couverture (10) sur ledit substrat au moyen d'un procédé entièrement épitaxial réalisé dans la chambre d'un réacteur pour dépôt chimique en phase vapeur, caractérisé en ce que ladite multiplicité de couches (10, N-, N+) est produite comme suit :
a. tirage d'une première sous-couche de couverture relativement mince au-dessus du substrat et purgeage de ladite chambre à l'hydrogène pour appauvrir en dopant ladite première sous-couche ;
b. tirage d'une seconde sous-couche de couverture relativement mince au-dessus de la première sous-couche et purgeage de ladite chambre à l'hydrogène pour appauvrir en dopant ladite seconde sous-couche ;
c. tirage d'une couche épitaxiale relativement légèrement dopée (N-) au-dessus de ladite seconde sous-couche ; et
d. tirage d'une couche épitaxiale relativement fortement dopée (N+) du type de polarité opposée audit substrat (P+) au-dessus de ladite couche épitaxiale relativement légèrement dopée (N-).

17. Le procédé selon la Revendication 16, selon lequel le substrat a une résistivité inférieure à 0,0035 ohm-cm.

18. Le procédé selon la Revendication 16, selon lequel le substrat a une résistivité dans la plage de 0,001 à 0,002 ohm-cm.

19. Le procédé selon l'une quelconque des Revendications 16 à 18, selon lequel le tirage desdites sous-couches de couverture englobe l'étape de chauffage du substrat dans une atmosphère qui contient une source de silicium obtenue depuis un groupe de composés comportant trichlorosilane, chlorosilane et silane.

20. Le procédé selon l'une quelconque des Revendications 16 à 19, selon lequel le tirage de ladite couche légèrement dopée est réalisé dans une atmosphère d'hydrogène à une température comprise entre 1000°C et 1200°C.

21. Le procédé selon l'une quelconque des Revendications 16 à 20, selon lequel ladite couche légèrement dopée a une résistivité inférieure à 200 ohms-cm.

22. Le procédé selon la Revendication 21, selon lequel ladite couche légèrement dopée a une résistivité inférieure à 50 ohms-cm.

23. Le procédé selon l'une quelconque des Revendications 16 à 22, selon lequel ladite couche légèrement dopée a une épaisseur de 5 à 100 microns.

24. Le procédé selon l'une quelconque des Revendications 16 à 23, selon lequel ladite couche fortement dopée est tirée sur ladite couche légèrement dopée dans un environnement gazeux qui est la source de dopant sélectionnée parmi l'arsenic, le phosphore et l'antimoine.
